# EUROPEAN PATENT SPECIFICATION

(11) **EP 3 610 982 B1**
(45) Date of publication and mention of the grant of the patent: **17.07.2024**
(21) Application number: 19190736.9
(22) Date of filing: 08.08.2019
(51) Int. Cl.: B23K 26/244, H01R 43/00, B23K 101/36

(54) **METHOD OF ATTACHING AT LEAST ONE PIN-SHAPED CONTACT ELEMENT TO A CONDUCTIVE PATH OF A CONDUCTOR PLATE, PIN HEADER FOR ATTACHING TO A CONDUCTOR PLATE, CONNECTION ASSEMBLY**
VERFAHREN ZUM ANBRINGEN MINDESTENS EINES STIFTFÖRMIGEN KONTAKTELEMENTS AN EINER LEITERBAHN EINER LEITERPLATTE, STIFTLEISTE ZUR BEFESTIGUNG AN EINER LEITERPLATTE, VERBINDUNGSANORDNUNG
PROCÉDÉ DE FIXATION D'AU MOINS UN ELEMENT DE CONTACT EN FORME DE BROCHE SUR UN TRAJET CONDUCTEUR D'UNE PLAQUE CONDUCTRICE, EN-TÊTE DE BROCHE POUR FIXATION SUR UNE PLAQUE CONDUCTRICE, ENSEMBLE DE CONNEXION

(30) Priority: 14.08.2018 DE 102018213639
(43) Date of publication of application: 19.02.2020
(73) Proprietor: TE Connectivity Germany GmbH, 64625 Bensheim (DE)
(72) Inventor: DRESSEL, Andre Martin, 68623 Lampertheim (DE); CHRITZ, Gunther, 69488 Birkenau (DE); HUBER, Jens, 64646 Heppenheim (DE)
(74) Representative: Grünecker Patent- und Rechtsanwälte PartG mbB

(56) References cited:
- DE-A1- 102010 030 070
- US-A1- 2018 045 232
- TE CONNECTIVITY: "Datasheet Surface Mount Pin Header", 22 June 2017 (2017-06-22), XP002796338, Retrieved from the Internet <URL:https://eu.mouser.com/datasheet/2/418/NG_CD_794628_H1-1260035.pdf> [retrieved on 20191209]
- TE CONNECTIVITY: "Datasheet Surface Mount Pin Header", INTERNET CITATION, 22 June 2017 (2017-06-22), XP002796338, Retrieved from the Internet <URL:https://eu.mouser.com/datasheet/2/418/NG_CD_794628_H1-1260035.pdf> [retrieved on 20191209]

## Description

The invention relates to a method of attaching at least one, in particular pin-shaped, contact element to a conductive path of a conductor plate. Furthermore, the invention relates to a pin header for attaching to a conductor plate, and to a connection assembly.

There are various methods in existence regarding how a contact element can be attached to a conductive path of a conductor plate. The contact element can be attached by soldering, for example. To do this, it is necessary to use flux which, where appropriate, must be removed in the further progression of the production method. A further possibility is production in through-hole technology (THT). However, this requires the drilling of holes. The specified methods are thus complex.

In order to provide a solution which is less complex, in a method of attaching at least one, in particular pin-shaped, contact element to a conductive path of a conductor plate, the contact element is welded to the conductive path in a surface-mounted manner by means of a laser beam.

In order to provide a solution that allows a better distribution of the heat during the welding, the laser beam is guided along a spiral path on a surface.

A corresponding pin header for attaching to a conductor plate comprises at least one, in particular pin-shaped, contact element, wherein the at least one contact element is welded onto a surface of a conductive path of the conductor plate as a surface-mounted component. A corresponding connection assembly comprises a pin header and a conductor plate, wherein a contact element of the pin header is welded onto the conductive path of the conductor plate as a surface-mounted component.

With the specified solution, it is not necessary to use flux. Furthermore, it is possible to dispense with the drilling of holes. The outlay is reduced as a result.

In DE 10 2010 030 070 A1 a method of welding a flexible flat cable to a pin-shaped contact element is disclosed, wherein a plate that is transparent for a certain laser wavelength is glued to one side of the flexible flat cable to achieve a mechanical stability.

US 2018/0045232 A1 discloses a weld between a first material and a second material, the first material being a first metallic material, and the second material being a second metallic material, the weld has a width between 0.5 mm and 7 mm, the weld comprises at least one microweld, the microweld forms a welding pattern defined parallel to a surface of the first material, and the microweld has a characteristic feature size of between 20 µm and 400 um.

The object of the invention is to provide a solution that improves the welding process and allows a better distribution of the heat during the welding.

According to the invention, this is achieved in that in a middle region, which is situated between a first end and a second end, the contact element is substantially pin-shaped, and is characterized in that one end, which is to be welded, of the contact element is flattened before welding. This enable particularly good heating during a welding process. As a result, the end to be welded can be lightly heated by the laser beam. A correspondingly shaped end is flat.

The solution according to the invention can be further improved with the following further developments and configurations which are each advantageous and able to be combined with one another as desired.

The contact element can in particular be welded onto the surface of the conductive path. The method can be particularly simple as a result.

In the case of an advantageous configuration of the method, it is possible to entirely dispense with the drilling of holes, in order to keep the method simple. In the case of an advantageous configuration of a connection arrangement, there may consequently be no hole present on the conductor plate. All components can be mounted in a surface-mounted manner (Surface Mount Technology; SMT).

In a further configuration, the laser can be pulsed. This can lead to heating up which is restricted both in terms of duration and location, with neighbouring regions, in particular the conductor plate, being subjected to less thermal stress.

The laser beam is guided along a spiral path on a surface. In the case of such guiding of the beam, the heating can be well distributed along the path. Of course, other forms of the path are also possible, for instance a linear pattern. The surface can in particular be a surface of the contact element.

In order to keep thermal stress low, the laser beam may only locally fuse the material. For example, the laser may fuse the material only in a region with a radius which corresponds to 3.0 times the width of the laser beam. Advantageously, the region may also be smaller, for example only twice the width of the laser beam or only, for instance, the single width of the laser beam. In this case, the width of the laser beam can be defined as, for example, the distance between two opposing points at which the intensity has dropped to 1/e².

The laser beam can be focussed on a region which is smaller than one-tenth of the thickness of the contact element. Thereafter, the heating can be locally limited.

In order to keep the distance between the contact elements and thus the insulation distance large when using several contact elements, the at least one, in particular pin-shaped, contact element can be part of a pin header with several, in particular pin-shaped, contact elements that are arranged in several rows which are offset from one another. An angle between two lines which connect the contact element to an adjacent contact element can be unequal to 90 degrees, in particular approximately 60 degrees. The contact elements can be arranged in a hexagonal grid.

For example, the contact element end to be welded can be embossed or rolled. Such a configuration can be particularly easy to implement.

In order to enable particularly good welding between the two, the ratio of a thickness of the conductive path to a thickness of the contact element can be at least 0.3. The ratio should be a maximum of 2.0. The thickness can in this case be measured in particular at the flattened end and be the smallest dimension between two flat sides there, for example a front side and a rear side.

The first end, which is to be welded, of the contact element can in particular be configured in the shape of a disc in order to enable simple heating. For example, this can be a circular disc, for instance.

In the attached state, the end to be welded can run parallel to a surface of the conductor plate in order to enable simple and extensive welding.

The contact element, in particular a contact element end which is to be welded, can be able to be welded onto a conductive path or appropriately configured landing surface.

In order to enable simple contacting to a mating plug, a second end of the contact element can be configured for connection to a mating plug. The second end can, for this purpose, be configured as a protruding pin or as a socket which is able to be joined together with a corresponding mating element. For this purpose, contact elements can be formed in accordance with company standards or national or international standards for plugs.

The pin header can have several contact elements which are all surface-mounted. This enables particularly simple mounting.

The invention is explained below by way of example and in greater detail on the basis of advantageous configurations with reference to the drawings. The advantageous further developments and configurations depicted in this instance are each independent of one another and can be combined with one another as desired, depending on how this is necessary in the specific application.

In the drawings:
Fig. 1 shows a schematic perspective view of a pin header
Fig. 2 shows a schematic lateral cross-sectional view of a contact element on a conductor plate;
Fig. 3 shows a schematic perspective view of a detail of a contact element
Fig. 4 shows a schematic perspective view of a detail of a path;
Fig. 5 shows a schematic cross-sectional view of an assembly of several contact elements.

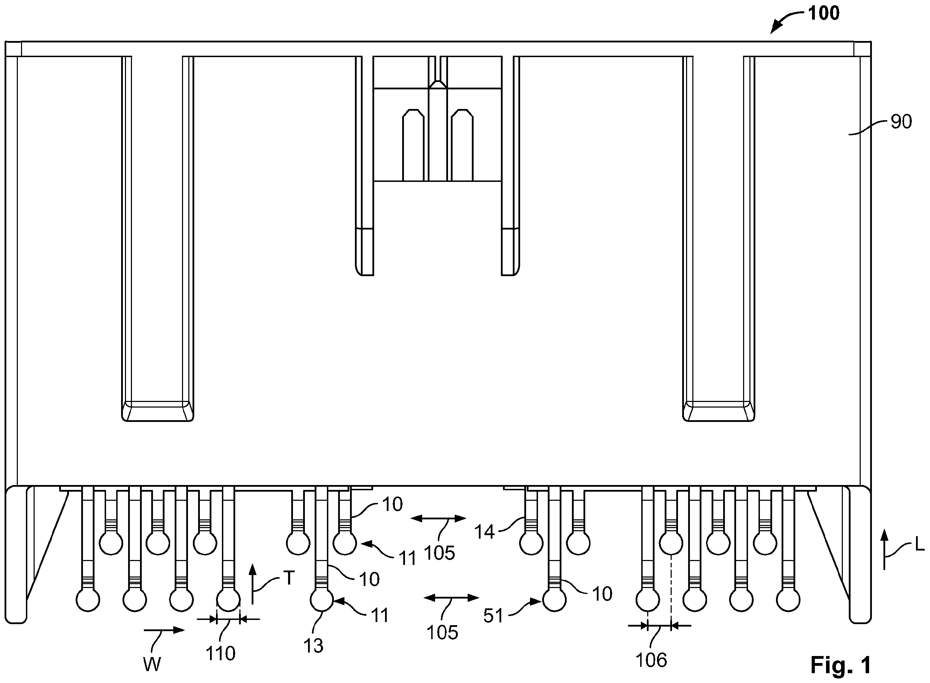

Figure 1 shows a pin header 100. Such a pin header 100 is also known as a header. It is attached to a conductor plate 20, wherein the pin header 100 has several contact elements 10 which are connected to conductive paths 21 on the conductor plate 20. On the other side, opposite the side with the conductor plate 20, the pin header 100 can have a plug-in face so that they can be connected to a mating plug (not shown). The plug-in face can be configured in accordance with internal or external standards, so that it can be plugged together with a mating plug according to such standards.

The contact elements 10 are arranged in a housing 90 that can be made out of an insulating plastic, for example.

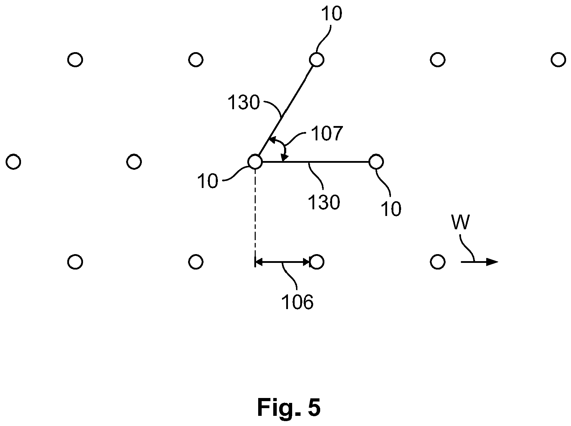

As can be seen in Figures 1 and 5, the contact elements 10 are arranged in several rows 105, with adjacent rows 105 being offset from one another by an offset 106. The individual contact elements 10 are arranged in a hexagonal grid, so that a central contact element 10 is surrounded by six further contact elements 10, from each of which it has the same distance 130. Three contact elements in each case consequently form an equilateral triangle. An angle 107, measured between three contact elements with a contact element 10 as the base, is 60 degrees.

In other configurations, the angle can be smaller or larger, depending on how the distance between the individual rows 105 and the distance 130 between the individual contact elements 10 in a row 105 is.

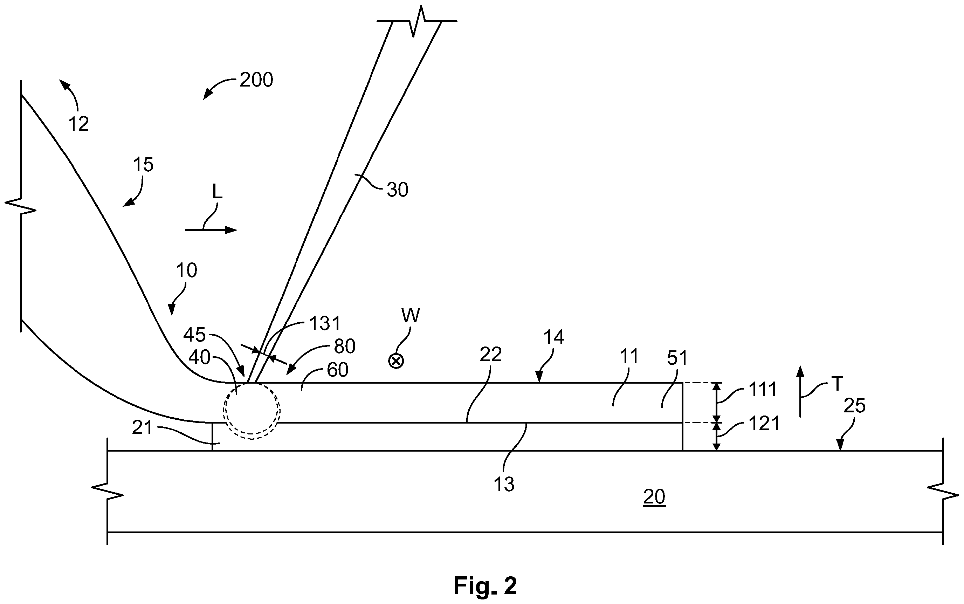

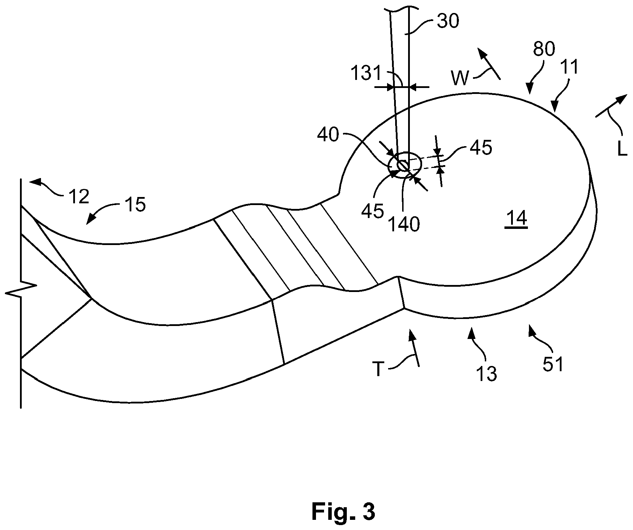

It can be seen in particular in Figures 2 and 3 that a first end 11, to be welded, of the contact element 10 is flattened. In the example shown, the first end 11 is configured as a disc 51 which is circular, for instance. A thickness 111 of the first end 11, measured in a thickness direction T which is measured perpendicular to the plane of the flat first end 11 and perpendicular to the surface 25 of the conductor plate 20, is in terms of magnitude in the region of a thickness 121 of the conductive path 21 on the conductor plate 20. This enables good welding of them both to one another. In general, the ratio of the thickness 121 of the conductive path 21 to the thickness 111 of the contact element 10, in particular of the first end 11, should be at least 0.3. A value of 2.0 can be regarded as a maximum ratio to obtain a good welding result.

The flattening can be achieved by a stamping or embossing process, for example.

A laser beam 30 is used to weld the contact element 10 to the conductive path 21. In this case, the laser beam 30 is directed onto a rear side 14 of the flat first end 11 of the contact element 10, wherein the rear side 14 should be regarded as the side opposite a front side 13 which is in contact with the conductive path 21. The front side 13 is in contact with a surface 22 of the conductive path 21 and is welded with this, or rather onto this.

The striking of the laser beam 30 onto the contact element 10 causes a heating, in particular a melting, so that the contact element 10 is welded with the conductive path 21, or rather onto the conductive path 21. A width 131 of the laser beam 30 and the region 45 onto which the laser beam 30 is focussed, are in this case chosen to be so small that the fused region 40 has a width 140, which is small compared to a width 110 of the contact element 10, in particular of the first end 11. As a result, the energy input and the warming-up are kept minimal so that the conductor plate 20, which is heat-sensitive, incurs no damage. Advantageously, the width 45 onto which the laser beam 30 is focussed, and/or the width 140 of the heated regions 40 are smaller than the width 111 of the contact element 10 by a factor of 10 or more.

In order to restrict the local fusing of the material 60 still further, the laser can be pulsed, so that only short intensive laser pulses strike the surface 80.

The contact elements 10 shown are substantially pin-shaped, in particular in a middle region 15, which is situated between the first end 11 and the second end 12. They extend along a longitudinal direction L which is perpendicular to the width direction W and perpendicular to the thickness direction T, wherein the thickness direction T is in turn perpendicular to the width direction W.

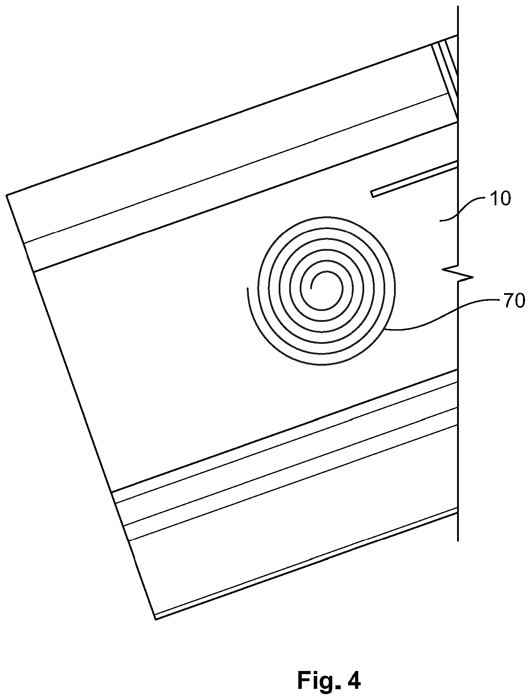

As can be seen in Fig. 4, a path 70 along which the laser beam 30 is guided can be spiral-shaped. This can, for example, lead to a heated region 40 having sufficient time to cool before the laser beam 30 causes heating in its vicinity in a further round.

The pin header 100 is configured such that all of the contact elements 10 shown can be mounted on the conductor plate 20 in a surface-mounted manner. In particular, it is not necessary to bore holes into the conductor plate 20. The outlay in terms of manufacture is therefore reduced. Through the use of a pulsed laser which achieves heating only locally in a small region 40, it is nevertheless possible to bring about a welding between the contact element 10 and the conductive path 21 without the conductor plate 21 being exposed to high temperatures.

### Reference symbols

- 10: contact element
- 11: first end, to be welded
- 12: second end
- 13: front side
- 14: rear side
- 15: middle region
- 20: conductor plate
- 21: conductive path
- 25: surface of the conductor plate
- 30: laser beam
- 40: region
- 45: focus region
- 51: disc
- 60: material
- 70: path
- 71: spiral path
- 80: surface
- 90: housing
- 100: pin header
- 105: row
- 106: offset
- 107: angle
- 110: width contact element
- 111: thickness, first end
- 121: thickness, conductive path
- 130: distance
- 131: width, laser beam
- 140: width of the region
- 200: connection assembly

- L: longitudinal direction
- T: thickness direction
- W: width direction

## Claims

1. A method of attaching at least one pin-shaped contact element (10) to a conductive path (21) of a conductor plate (20), wherein the contact element (10) is welded to the conductive path (21) in a surface-mounted manner by means of a laser beam (30), wherein the laser beam (30) is guided along a spiral path (70) on a surface (80), wherein in a middle region (15), which is situated between a first end (11) and a second end (12), the contact element (10) is pin-shaped, and **characterized in that** the first end (11), which is to be welded, of the contact element (10) is flattened before welding.

2. The method according to claim 1, wherein the contact element (10) is welded onto the surface (22) of the conductive path (21).

3. The method according to claim 1 or 2, wherein the laser is pulsed.

4. The method according to any one of claims 1 to 3, wherein the laser beam (30) melts the material (60) on only locally.

5. The method according to any one of claims 1 to 4, wherein the laser beam (30) is focussed on a region (45) which is smaller than one-tenth of the thickness (111) of the contact element (10).

6. The method according to any one of claims 1 to 5, wherein the at least one, in particular pin-shaped, contact element (10) is part of a pin header (100) having several, in particular pin-shaped, contact elements (10) arranged in several rows (105) which are offset from one another.

7. The method according to any one of claims 1 to 6, wherein the contact element (10) end (11) to be welded is stamped or rolled.

8. The method according to any one of claims 1 to 7, wherein the ratio of a thickness (121) of the conductive path (21) to a thickness (111) of the contact element (11) is at least 0.3.

9. A pin header (100) for attaching to a conductor plate (20), comprising at least one pin-shaped contact element (10), wherein the at least one contact element (10) is configured to be welded onto a surface (22) of a conductive path (21) of the conductor plate (20) as a surface-mounted component, **characterized in that** the at least one contact element (10) is configured to be laser-welded onto the surface (22) of the conductive path (21) along a spiral path (70) on the surface (80), wherein a first end (11), which is to be welded, of the contact element (10) is flat and in a middle region (15), which is situated between the first end (11) and a second end (12), the contact element (10) is pin-shaped.

10. The pin header (100) according to claim 9, wherein the first end (11) of the contact element (10) is configured to be disc-shaped.

11. The pin header (100) according to any one of claims 9 or 10, wherein the pin header (100) has several rows (105) of contact elements (10) and the contact elements (10) in adjacent rows (105) are offset from one another.

12. A connection assembly (200), comprising a pin header (100) according to any one of claims 9 to 11, and a conductor plate (20), wherein a contact element (10) of the pin header (100) is welded onto the conductive path (21) of the conductor plate (20) as a surface-mounted component.

13. The connection assembly (200) according to claim 12, wherein the pin header has several contact elements which are all surface-mounted.

## Patentansprüche

1. Verfahren zum Anbringen mindestens eines stiftförmigen Kontaktelements (10) an einer Leiterbahn (21) einer Leiterplatte (20), wobei das Kontaktelement (10) mittels eines Laserstrahls (30) flächig mit der Leiterbahn (21) verschweißt wird, wobei der Laserstrahl (30) entlang einer Spiralbahn (70) auf einer Oberfläche (80) geführt wird, wobei das Kontaktelement (10) in einem mittleren Bereich (15), der sich zwischen einem ersten Ende (11) und einem zweiten Ende (12) befindet, stiftförmig ist, und **dadurch gekennzeichnet, dass** das zu verschweißende erste Ende (11) des Kontaktelements (10) vor dem Verschweißen abgeflacht wird.

2. Verfahren nach Anspruch 1, wobei das Kontaktelement (10) auf die Oberfläche (22) der Leiterbahn (21) aufgeschweißt wird.

3. Verfahren nach Anspruch 1 oder 2, wobei der Laser gepulst ist.

4. Verfahren nach einem der Ansprüche 1 bis 3, wobei der Laserstrahl (30) das Material (60) nur lokal aufschmilzt.

5. Verfahren nach einem der Ansprüche 1 bis 4, wobei der Laserstrahl (30) auf einen Bereich (45) fokussiert wird, der kleiner als ein Zehntel der Dicke (111) des Kontaktelements (10) ist.

6. Verfahren nach einem der Ansprüche 1 bis 5, wobei das mindestens eine, insbesondere stiftförmige, Kontaktelement (10) Teil einer Stiftleiste (100) ist, die mehrere, insbesondere stiftförmige, Kontaktelemente (10) aufweist, die in mehreren, zueinander versetzten Reihen (105) angeordnet sind.

7. Verfahren nach einem der Ansprüche 1 bis 6, wobei das zu verschweißende Ende (11) des Kontaktelements (10) gestanzt oder gewalzt wird.

8. Verfahren nach einem der Ansprüche 1 bis 7, wobei das Verhältnis einer Dicke (121) der Leiterbahn (21) zu einer Dicke (111) des Kontaktelements (11) mindestens 0,3 beträgt.

9. Stiftleiste (100) zur Befestigung an einer Leiterplatte (20), mit mindestens einem, stiftförmigen, Kontaktelement (10), wobei das mindestens eine Kontaktelement (10) konfiguriert ist, auf eine Oberfläche (22) einer Leiterbahn (21) der Leiterplatte (20) als Aufbauteil aufgeschweißt ist, **dadurch gekennzeichnet, dass** das mindestens eine Kontaktelement (10) konfiguriert ist entlang einer spiralförmigen Bahn (70) auf der Oberfläche (80) auf die Oberfläche (22) der Leiterbahn (21) lasergeschweißt ist, wobei ein zu verschweißendes erstes Ende (11) des Kontaktelements (10) flach ist und in einem mittleren Bereich (15), der zwischen dem ersten Ende (11) und einem zweiten Ende (12) liegt, das Kontaktelement (10) stiftförmig ist.

10. Stiftleiste (100) nach Anspruch 9, wobei das erste Ende (11) des Kontaktelements (10) konfiguriert ist scheibenförmig ausgebildet zu sein.

11. Stiftleiste (100) nach einem der Ansprüche 9 oder 10, wobei die Stiftleiste (100) mehrere Reihen (105) von Kontaktelementen (10) aufweist und die Kontaktelemente (10) in benachbarten Reihen (105) gegeneinander versetzt sind.

12. Anschlussbaugruppe (200), umfassend eine Stiftleiste (100) nach einem der Ansprüche 9 bis 11 und eine Leiterplatte (20), wobei ein Kontaktelement (10) der Stiftleiste (100) auf die Leiterbahn (21) der Leiterplatte (20) als Aufbauteil aufgeschweißt ist.

13. Anschlussbaugruppe (200) nach Anspruch 12, wobei die Stiftleiste mehrere Kontaktelemente aufweist, die alle oberflächenmontiert sind.

## Revendications

1. Procédé de fixation d'au moins un élément de contact en forme de broche (10) à un chemin conducteur (21) d'une plaque conductrice (20), dans lequel l'élément de contact (10) est soudé au chemin conducteur (21) de manière à être monté en surface au moyen d'un faisceau laser (30), dans lequel le faisceau laser (30) est guidé le long d'un chemin en spirale (70) sur une surface (80), dans lequel, dans une région médiane (15), qui est située entre une première extrémité (11) et une deuxième extrémité (12), l'élément de contact (10) est en forme de broche, et **caractérisé en ce que** la première extrémité (11), qui doit être soudée, de l'élément de contact (10) est aplatie avant le soudage.

2. Procédé selon la revendication 1, dans lequel l'élément de contact (10) est soudé sur la surface (22) du chemin conducteur (21).

3. Procédé selon la revendication 1 ou 2, dans lequel le laser est pulsé.

4. Procédé selon l'une quelconque des revendications 1 à 3, dans lequel le faisceau laser (30) ne fait fondre le matériau (60) que localement.

5. Procédé selon l'une quelconque des revendications 1 à 4, dans lequel le faisceau laser (30) est focalisé sur une région (45) qui est inférieure au dixième de l'épaisseur (111) de l'élément de contact (10).

6. Procédé selon l'une quelconque des revendications 1 à 5, dans lequel l'au moins un élément de contact (10), notamment en forme de broche, fait partie d'une embase de broches (100) ayant plusieurs éléments de contact (10), notamment en forme de broche, agencés en plusieurs rangées (105) qui sont décalés les uns par rapport aux autres.

7. Procédé selon l'une quelconque des revendications 1 à 6, dans lequel l'extrémité (11) de l'élément de contact (10) à souder est emboutie ou laminée.

8. Procédé selon l'une quelconque des revendications 1 à 7, dans lequel le rapport de l'épaisseur (121) du chemin conducteur (21) sur l'épaisseur (111) de l'élément de contact (11) est d'au moins 0,3.

9. Embase de broches (100) destinée à être fixée à une plaque conductrice (20), comprenant au moins un élément de contact en forme de broche (10), dans laquelle l'au moins un élément de contact (10) est configuré pour être soudé sur une surface (22) d'un chemin conducteur (21) de la plaque conductrice (20) en tant que composant monté en surface, **caractérisée en ce que** l'au moins un élément de contact (10) est configuré pour être soudé au laser sur la surface (22) du chemin conducteur (21) le long d'un chemin en spirale (70) sur la surface (80), dans laquelle une première extrémité (11), qui doit être soudée, de l'élément de contact (10) est plate et, dans une région médiane (15), qui est située entre la première extrémité (11) et une deuxième extrémité (12), l'élément de contact (10) est en forme de broche.

10. Embase de broches (100) selon la revendication 9, dans laquelle la première extrémité (11) de l'élément de contact (10) est configurée pour être en forme de disque.

11. Embase de broches (100) selon l'une quelconque des revendications 9 ou 10, dans laquelle l'embase de broches (100) a plusieurs rangées (105) d'éléments de contact (10) et les éléments de contact (10) dans des rangées adjacentes (105) sont décalés les uns par rapport aux autres.

12. Ensemble de connexion (200), comprenant une embase de broches (100) selon l'une quelconque des revendications 9 à 11, et une plaque conductrice (20), dans lequel un élément de contact (10) de l'embase de broches (100) est soudé sur le chemin conducteur (21) de la plaque conductrice (20) en tant que composant monté en surface.

13. Ensemble de connexion (200) selon la revendication 12, dans lequel l'embase de broches a plusieurs éléments de contact qui sont tous montés en surface.
